# EUROPÄISCHE PATENTANMELDUNG

(11) **EP 3 297 410 A1**
(43) Veröffentlichungstag der Anmeldung: **21.03.2018**
(21) Anmeldenummer: 16189428.2
(22) Anmeldetag: 19.09.2016
(51) Int. Cl.: H05K 3/12, H01L 23/538

(54) **LÖTSCHABLONE UND VERFAHREN ZUR HERSTELLUNG EINER LEITRPLATTENANORDNUNG**

(71) Anmelder: ZF Friedrichshafen AG, 88046 Friedrichshafen (DE); A.B. Mikroelektronik Gesellschaft mit beschränkter Haftung, 5020 Salzburg (AT)
(72) Erfinder: Schwab, Manuel, 8280 Kreuzlingen (CH); Birk, Alexander, 88441 Mittelbiberach (DE); Karch, Andreas, 83236 Übersee (DE); Burns, Robert Christopher, 5020 Salzburg (AT); Tusler, Wolfgang, 5020 Salzburg (AT); Wein, Florian, 83435 Bad Reichenhall (DE)

(57) **Zusammenfassung**

Die Erfindung betrifft eine Lötschablone (8) zur Herstellung einer Leiterplattenanordnung, die über eine vorgefertigte Trägerplatte (1) mit einer Bauteilseite mit zumindest zwei darauf vorbestückten elektrischen Bauteilen (3, 4) verfügt und die über eine Leiterplatte (1) verfügt, die mit den Bauteilen (3, 4) auf der Bauteilseite der Trägerplatte (2) mittels Lotpaste verlötet ist, wobei in der Lötschablone (8) mehrere erste Fenster (3A, 4A) für jedes der Bauteile (3, 4) vorgesehen sind, zum Aufbringen von Lotpaste in jeweils ein Lotpastedepot auf die Leiterplatte (1), das zur Herstellung der Lötverbindung (6) zwischen den Bauteilen (3, 4) und der Leiterplatte (1) dient. Dabei weisen die ersten Fenster (3A, 4A) über ausreichend Abstand zueinander auf, um Ausgasungskanäle (9) zwischen den Lotpastedepots zu bilden. Die Erfindung betrifft auch ein Verfahren zur Herstellung einer Leiterplattenanordnung mittels einer solchen Lötschablone (8).

## Beschreibung

Die Erfindung betrifft ein Verfahren und eine Lötschablone zur Herstellung einer Leiterplattenanordnung.

Aus dem Stand der Technik sind Lötschablonen bekannt, wie beispielsweise aus der DE 100 43 471 A1.

Lötschablonen dienen zum gezielten Auftragen von Lotpaste in Lotpastedepots, wie beispielsweise auf Leiterplatten. Im Detail verfügt eine Lötschablone über Fenster, die mit denjenigen Stellen der Leiterplatte korrespondieren, an welchen später eine Lötverbindung hergestellt werden soll. Die Lötschablone wird auf die Leiterplatte aufgelegt, und Lotpaste darauffolgend in einem Schablonendruck-Verfahren aufgebracht. Dadurch werden die Fenster mit Lotpaste befüllt und das jeweilige Lotpastedepot gebildet. Nach Abnehmen der Lötschablone von der Leiterplatte verbleibt je Fenster also ein Lotpastedepot. Auf diese werden dann beispielsweise elektrische Bauteile etc. aufgelegt. Daraufhin wird die Lotpaste im Lotpastedepot durch Erhitzen aufgeschmolzen und die Lötverbindung zwischen Bauteil und Leiterplatte hergestellt. Lötschablonen bestehen in der Regel aus einem Metall, in welchem die Fenster als feine Linien, Rechtecke oder andersförmige Öffnungen für die Lotpaste ausgebildet sind.

Das Aufschmelzen der Lotpaste erfolgt üblicherweise im Rahmen eines so genannten Reflow-Prozesses. Hierbei wird die Lotpaste zusammen mit den zu verbindenden Elementen erhitzt und die Lotpaste dadurch aufgeschmolzen. Wenn eine Leiterplatte mittels Lotpaste verlötet werden soll, entstehen während dieses Reflow-Prozesses thermische Spannungen innerhalb der Leiterplatte. Diese führen regelmäßig zu einer Verbiegung der Leiterplatte. Sie wird durch unsymmetrisch verteilte Leiterbahnen auf der Leiterplatte begünstigt. Beim großflächigen Auflöten von elektrischen Bauteilen oder vorgefertigten Bauteilgruppen auf eine Leiterplatte, muss daher die Lotschablone dick genug sein, um ausreichend hohe Lotpastedepots zu schaffen, die die Lötverbiegungen zwischen der Leiterplatte und dem aufzulötenden elektrischen Bauteil / Bauteilgruppe erzeugen können.

Darüber hinaus entstehen während des Reflow-Prozesses Ausgasungen aus der Lotpaste. Diese entstehen durch freigesetztes Prozessgas aus dem der Lotpaste zugesetzten Flussmittels. Bei relativ großen Lötflächen und/oder hohen Lotpastedepots entsteht entsprechend viel Prozessgas, das ausgasen muss. Durch Vorsehen eines Vakuums bzw. Unterdrucks während des Lötprozesses können zwar große Teile dieser Ausgasungen aus dem flüssigen Lotmaterial entfernt werden. Jedoch wird dabei neben dem Prozessgas ebenso flüssiges Lotmaterial unkontrolliert aus dem Lötverbindungsbereich herausgespritzt. Dieses Lotmaterial verbleibt anschließend als Lotspritzer auf dem Bauteil und/oder der Leiterplatte und kann zu Kurzschlüssen führen.

Durch Reduzierung der Höhe der Lotpastedepots kann zwar die Anzahl der Lotspritzer reduziert oder diese ganz vermieden werden, es besteht dann allerdings das Risiko der Ausbildung von Hohlräumen oder Lücken in der Lötverbindung und damit einer schlechten elektrischen und thermischen Kontaktierung.

Aus der EP 0593986 A1 ist es daher bekannt, eine Riffelung auf einer Leiterplatte vorzusehen, um eine Entlüftung für Prozessgas bereitzustellen.

Aus der US 7,696,594 B2 ist es bekannt, mittels einer Lötschablone mit mehreren zueinander beabstandeten Öffnungen, Lotpastedepots für ein elektrisches Bauteil auf ein PCB aufzubringen.

Aus der US 8,163,643 B1 ist es bekannt, mehrere Öffnungen in einer Lötstoppmaske als Lotpastedepots auf einer Leiterplatte zu verwenden.

Aufgabe der Erfindung ist es den Stand der Technik zu verbessern, insbesondere sollen Lotspritzer auf den zu verlötenden Bauteilen vermieden werden.

Diese Aufgabe wird durch die Gegenstände mit den Merkmalen der Hauptansprüche gelöst. Besondere Ausführungsformen davon sind den abhängigen Ansprüchen entnehmbar. Demnach werden vorgeschlagen: eine Lötschablone und ein Verfahren zur Herstellung einer Leiterplattenanordnung.

Mittels der vorgeschlagenen Lötschablone ist eine Leiterplattenanordnung herstellbar. Diese Leiterplattenanordnung verfügt über eine vorgefertigte Trägerplatte mit einer Bauteilseite mit zumindest oder genau zwei darauf vorbestückten elektrischen Bauteilen, wie beispielsweise ein Transistor und/oder eine Diode. Die Leiterplattenanordnung verfügt auch über eine Leiterplatte, die mit den elektrischen Bauteilen auf der Bauteilseite der vorgefertigten Trägerplatte mittels Lotpaste verlötet ist.

Mit der Lötschablone ist die Lotpaste auf die Leiterplatte für die Lötverbindung zwischen den elektrischen Bauteilen und der Leiterplatte aufbringbar. Es ist dazu vorgesehen, dass in der Lötschablone mehrere erste Fenster für jedes der elektrischen Bauteile auf der Bauteilseite der Trägerplatte vorgesehen sind, zum Aufbringen von Lotpaste in jeweils ein Lotpastedepot auf die Leiterplatte. Diese Lotpastedepots dienen zur Herstellung der Lötverbindung zwischen diesen Bauteilen und der Leiterplatte. Die ersten Fenster weisen zueinander ausreichend Abstand auf, um Ausgasungskanäle zwischen den durch sie erzeugten Lotpastedepots zu bilden.

Somit dient die Lötschablone also zum Verlöten gleich mehrerer elektrischer Bauteile auf der Leiterplatte. Je elektrisches Bauteil sind mehrere erste Fenster in der Lötschablone vorgesehen, um jeweils ein Lotpastendepot zu erzeugen. Diese ersten Fenster sind so ausreichend weit voneinander beabstandet, dass sich zwischen den durch sie gebildeten Lotpastendepots die Ausgasungskanäle ausbilden.

Diese Ausgasungskanäle dienen zur Abführung von Prozessgas während des Aufschmelzens der Lotpaste in den Lotpastendepots, also primär zur Ausgasung von Prozessgas aus dem Flussmittel der Lotpaste während des Reflow-Prozesses. Durch diese Ausgasungskanäle werden gegebenenfalls auch flüssige Rückstände des Flussmittels gezielt abgeführt. Somit können relativ großflächige und/oder hohe Lotpastedepots eingesetzt werden, ohne die Gefahr einer explosionsartigen Entweichung der Rückstände aus den Lotpastedepots und der daraus resultierenden Lotspritzer.

Dadurch, dass Lotspritzer verhindert werden und es somit zu keinen Lotspritzerbedingten Kurzschlüssen kommen kann, ist die damit hergestellte Leiterplattenanordnung besonders zuverlässig.

Durch die Lotvolumen in den Lotpastedepots werden nach dem Ausgasen die Ausgasungskanäle mit Lot gefüllt, um eine vollflächige Lötverbindung zu erhalten. Die ersten Fenster für das jeweilige elektrische Bauteil sind dazu in einem Ausführungsbeispiel ausreichend nah beieinander angeordnet, dass sich während des Aufschmelzens der Lotpaste die Ausgasungskanäle schlussendlich mit Lot aus der dort vorhandenen Lotpaste schließen.

In einem Teil der Lötschablone, welche mit einem Randbereich der Trägerplatte korrespondiert, können ein oder mehrere zweite Fenster vorgesehen sein. Diese zweiten Fenster dienen zum Aufbringen von Lotpaste in je ein Lotpastedepot, das zur Herstellung jeweils einer direkten Lötverbindung zwischen der Leiterplatte und der Trägerplatte dient. Durch die ersten Fenster werden demnach Lotpastedepots für Herstellung der direkten Kontaktierung der elektrischen Bauteile mit der Leiterplatte bereitgestellt und durch die zweiten Fenster werden Lotpastedepots für die Herstellung der direkten Kontaktierung der Trägerplatte mit der Leiterplatte bereitgestellt. Dadurch ist eine vollständige Kontaktierung der vorgefertigten Trägerplatte mit der Leiterplatte einfach ermöglicht.

Die zweiten Fenster können analog zu den ersten Fenstern ausgeführt sein. Somit können je direkter elektrischer Kontaktierung zwischen Leiterplatte und Trägerplatte mehrere zweite Fenster vorgesehen sein und diese können so zueinander beabstandet sein, dass sich Ausgasungskanäle zwischen den durch sie gebildeten Lotpastedepots ergeben. Alternativ kann je direkter elektrischer Kontaktierung zwischen Leiterplatte und Trägerplatte genau ein zweites Fenster vorgesehen sein, um jeweils lediglich ein einziges Lotpastendepot zu bilden. Letztere Möglichkeit wird insbesondere bei kleinflächigen direkten Kontaktierungen eingesetzt.

Es können zumindest zwei der zweiten Fenster vorgesehen sein. Dabei ist das bzw. sind die ersten Fenster zwischen diesen zweiten Fenstern angeordnet sind. Demnach befinden sich in der fertigen Leiterplattenanordnung die mit der Leiterplatte verlöteten elektrischen Bauteile räumlich zwischen den direkten Lötverbindungen von Leiterplatte und Trägerplatte.

Die ersten Fenster für das jeweilige elektrische Bauteil können auf einer viereckigen Grundfläche angeordnet sein, wobei erste Fenster an den Ecken der Grundfläche vorgesehen sind (Eckfenster) und diese gegenüber den anderen ersten Fenstern für dieses Bauteil vergrößert ausgeführt sind. Insbesondere weisen die Eckfenster gegenüber den anderen ersten Fenstern, die dazwischen angeordnet sind, eine größere Fläche auf. In der Draufsicht kann sich dadurch eine in etwa Schmetterlingsförmige Anordnung der ersten Fenster je elektrischen Bauteils ergeben. Diese Anordnung hat sich als besonders geeignet herausgestellt.

In einem Ausführungsbeispiel weist der Bereich der Leiterplatte, welcher mit der viereckigen Grundfläche korrespondiert, keine Lötstoppmaske auf. Somit ist er Lötstoppmaske-frei. Die Ausgasungskanäle werden dann also nicht durch eine Lötstoppmaske gebildet. Diese würde nämlich verhindern, dass sich die Ausgasungskanäle beim Aufschmelzen des Lots schlussendlich schließen und eine vollflächige Lötverbindung bilden. Somit würde sie an dieser Stelle die elektrische und thermische Kontaktierung verschlechtern.

Die ersten Fenster und gegebenenfalls auch die zweiten Fenster können so angeordnet sein, dass die Ausgasungskanäle zwischen den durch sie gebildeten Lotpastedepots rechtwinklig zueinander verlaufen. Zusätzlich oder alternativ können die ersten Fenster und gegebenenfalls auch die zweiten Fenster so angeordnet sein, dass die Ausgasungskanäle zwischen den durch sie gebildeten Lotpastedepots eine konstante Breite aufweisen. Diese Ausführungsformen haben sich ebenfalls als besonders geeignet zur Herstellung der Leiterplattenanordnung herausgestellt.

Es wird angemerkt, dass alternative Verläufe der Ausgasungskanäle möglich sind. Beispielsweise kann eine Breite der Ausgasungskanäle nach außen, also aus den Lotpastedepots heraus, zu- oder abnehmen. Ebenso können die Ausgasungskanäle sternförmig oder Schneeflocken-förmig verlaufen bzw. die Fenster für die Lotpastedepots entsprechend angeordnet sein.

Eine Ausführungsform der vorgeschlagenen Lötschablone dient zur Herstellung einer Leiterplattenanordnung, die über zwei oder mehr der vorgefertigten Trägerplatten verfügt und die über eine gemeinsame Leiterplatte verfügt, die mit den Bauteilen auf den Bauteilseiten dieser Trägerplatten mittels Lotpaste verlötet ist. Diese Lötschablone weist die ersten und gegebenenfalls auch die zweiten Fenster zum Aufbringen von Lotpaste in jeweils ein Lotpastedepot auf die gemeinsame Leiterplatte auf. Dabei sind die Fenster für eine der Trägerplatten bzw. deren Bauteile in einem ersten Bereich der Lötschablone angeordnet, und die Fenster für die andere der Trägerplatten bzw. deren Bauteile in einem anderen Bereich der Lötschablone angeordnet. Eine Dicke der Lötschablone ist hierbei in dem einen Bereich unterschiedlich zu der Dicke der Lötschablone in dem anderen Bereich. Dazu weist die Lötschablone beispielsweise eine Stufe oder eine Schräge zwischen den Bereichen auf.

Die mittels dieser Lötschablone erzeugbaren Lotpastedepots weisen somit in den unterschiedlichen Bereichen unterschiedliche Volumina und damit unterschiedliche Lotmassen auf. Eine der Trägerplatten bzw. die darauf vorbestückten Bauteile können dann vorab des Verlötens mit der gemeinsamen Leiterplatte bereits über Lotmasse hierfür verfügen, während die andere der Trägerplatten bzw. die darauf vorbestückten Bauteile vorab über keine oder weniger Lotmasse hierfür verfügen. Somit können unterschiedliche Arten von Trägerplatten und darauf vorbestückten Bauteilen mit der jeweils spezifisch erforderlichen Menge an Lotmasse mit der Leiterplatte verlötet werden.

Das vorgeschlagene Verfahren zur Herstellung der Leiterplattenanordnung sieht vor, dass in einem ersten Schritt auf die Leiterplatte Lotpaste in Lotpastedepots mittels der vorgeschlagenen Lötschablone aufgetragen wird. In einem zweiten Schritt wird dann die vorgefertigte Trägerplatte mit den elektrischen Bauteilen auf den Lotpastedepots auf der Leiterplatte angeordnet, d.h. die elektrischen Bauteile werden auf die Lotpastedepots der Leiterplatte aufgesetzt. In einem dritten Schritt wird dann die Lötverbindung zwischen den elektrischen Bauteile und der Leiterplatte durch Aufschmelzen der Lotpaste in den Lotpastedepots hergestellt. Dies erfolgt während des Reflow-Prozesses, insbesondere unter Unterdruck bzw. Vakuum.

Durch diese Vorgehensweise wird das aus der Lotpaste freigesetzte Prozessgas über die Ausgasungskanäle zwischen den Lotpastedepots abgeführt. Wenn der Ausgasungsvorgang beendet ist, füllen sich die Ausgasungskanäle mit flüssigem Lot aus den Depots. Somit ist die großflächige Lötverbindung zwischen den elektrischen Bauteilen und der Leiterplatte herstellbar.

Vorab des ersten Schrittes kann die Leiterplatte mit einer Lötstoppmaske, wie Lötstopplack, beschichtet werden. Der Bereich der Leiterplatte, der mit den elektrischen Bauteilen kontaktiert werden soll, kann dann unbeschichtet bleiben. Dieser Bereich verbleibt also vollständig Lötstoppmaske-frei. Die Ausgasungskanäle befinden sich in dem unbeschichteten, also Lötstoppmaske-freien Bereich. Somit wird einerseits ein flächiger elektrischer Kontakt zwischen den elektrischen Bauteilen und der Leiterplatte ermöglicht, andererseits wird ein ungewolltes Ausbreiten des Lots verhindert.

Wenn die mittels des Verfahrens herzustellende Leiterplattenanordnung auch eine direkte Lötverbindung zwischen der Leiterplatte und der Trägerplatte aufweisen soll, verfügt die Lötschablone über eines oder mehrere der genannten zweiten Fenster. Durch diese zweiten Fenster wird ein Lotpastedepot für diese direkte Lötverbindung geschaffen. Die Herstellung dieser direkten Lötverbindung erfolgt dann ebenfalls in dem dritten Schritt durch Aufschmelzen der Lotpaste in dem zugehörigen Lotpastedepot, also gleichzeitig mit dem Verlöten der elektrischen Bauteile mit der Leiterplatte.

Bei der Lotpaste kann es sich insbesondere um eine handelsübliche Lotpaste handeln. Die Lotpaste verfügt üblicherweise über Lotmetallpulver, das in Flussmittel eingemischt ist. Das Lotmetallpulver ist durch Erhitzen der Lotpaste aufschmelzbar. Dadurch bildet sich aus dem Lotmetallpulver eine massive Lotmasse bzw. Lötverbindung. Das Flussmittel wird hierbei zumindest zum Teil ausgedampft.

Im Folgenden wird die Erfindung anhand von Figuren näher erläutert, aus welchen weitere Ausführungsformen der Erfindung entnehmbar sind. Die Figuren zeigen dabei in schematischer Darstellung:
Fig. 1 eine Leiterplattenanordnung,
Fig. 2 eine Lötschablone in einer Draufsicht,
Fig. 3 eine Lötschablone in einem Längsschnitt.

In den Figuren sind gleiche oder zumindest funktionsgleiche Bauteile / Elemente mit gleichen Bezugszeichen versehen.

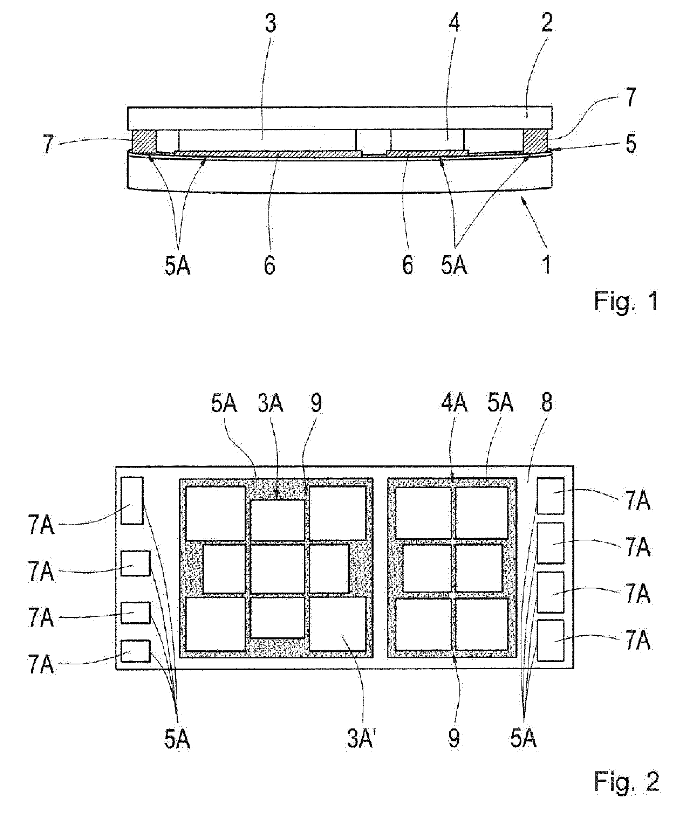

Fig. 1 zeigt einen Teil einer Leiterplattenanordnung mit einer Leiterplatte 1 und einer Trägerplatte 2. Die Trägerplatte 2 ist vorgefertigt mit darauf vorbestückten elektrischen Bauteilen 3, 4 auf einer gemeinsamen Bauteilseite der Trägerplatte 2. Somit bildet die Trägerplatte 2 mit den Bauteilen 3, 4 ein Modul, das zur Herstellung der Leiterplattenanordnung auf die Leiterplatte 1 aufgesetzt wird und damit verbunden wird. Eine zur Bauteilseite gegenüberliegende Seite der Trägerplatte 2 (in Fig. 1 oben) weist beispielsweise keine elektrischen Bauteile auf.

Vorliegend sind die Bauteile 3, 4 mit einer Seite auf die Trägerplatte 2 aufgesintert. Dies ist im Rahmen der Vorfertigung der Trägerplatte 2 erfolgt. Eine gegenüberliegende andere Seite der Bauteile 3, 4 ist auf die Leiterplatte 1 mittels Lotpaste 5 aufgelötet. Dies ist im Rahmen eines Reflow-Prozesses erfolgt, wozu vorher Lotpaste in Lotpastedepots mittels einer Lötschablone auf die Leiterplatte 1 aufgebracht wurde. Vorab kann die Leiterplatte 1 auch mit einer Lötstoppmaske 5 beschichtet worden sein. Die Lötverbindung zwischen den Bauteilen 3, 4 und der Leiterplatte 1 ist mit dem Bezugszeichen 6 versehen.

Die Trägerplatte 2 ist darüber hinaus mit der Leiterplatte 1 in einem Randbereich der Trägerplatte 2 ebenfalls mittels Lotpaste direkt verlötet. Diese direkte Lötverbindung zwischen der Trägerplatte 2 und der Leiterplatte 1 ist mit dem Bezugszeichen 7 versehen. Durch die Lötverbindungen 6, 7 sind die elektrischen Bauteile 3, 4 vollständig mit der Leiterplatte 1 elektrisch kontaktiert.

Wie erläutert, zeigt Fig. 1 lediglich einen Teil der Leiterplatte 1. Auf der gesamten Leiterplatte 1 können noch beliebig viele weitere solcher vorgefertigten Trägerplatten angeordnet sein.

Fig. 2 zeigt eine Lötschablone 8, um Lotpaste in Lotpastedepots auf der in Fig. 1 gezeigten Leiterplatte 1 im Rahmen deren Herstellungsprozesses anzuordnen. Die Lötschablone 8 dient also zur Herstellung einer Leiterplattenanordnung gemäß Fig. 1.

Die Lötschablone 8 verfügt dazu über mehrere erste Fenster 3A für das Bauteil 3 sowie mehrere erste Fenster 4A für das Bauteil 4. Da das Bauteil 3 flächenmäßig mehr Platz in Anspruch nimmt, als das Bauteil 4, sind mehr Fenster 3A als Fenster 4A vorgesehen. Darüber hinaus sind zweite Fenster 7A in der Lötschablone 8 vorgesehen. Die Fenster 3A, 4A, 7A dienen zum Aufbringen von Lotpaste in jeweils ein Lotpastedepot auf die Leiterplatte 1, zur Herstellung der Lötverbindungen 6 zwischen den Bauteilen 3, 4 und der Leiterplatte 1 (Fenster 3A, 4A) sowie zur Herstellung der direkten Lötverbindungen 7 zwischen der Trägerplatte 2 und der Leiterplatte 1 (Fenster 7A).

Die ersten Fenster 3A, 4A sind somit in einem Bereich der Lötschablone 8 angeordnet, der mit einem Bereich der Leiterplatte 1 bzw. Trägerplatte 2 korrespondiert, auf dem die Bauteile 3, 4 angeordnet werden/sind. Und die zweiten Fenster 7A sind demnach in einem Bereich der Lötschablone 8 angeordnet, die mit Randbereichen der Leiterplatte 2 bzw. Trägerplatte 2 korrespondieren, die für die direkten Lötverbindungen 7 vorgesehen sind. Da die Bauteile 3, 4 zwischen den Lötverbindungen 7 angeordnet sind, sind auch die ersten Fenster 3A, 4A zwischen den zweiten Fenstern 7A angeordnet.

Es ist vorgesehen, dass zumindest die ersten Fenstern 3A, 4A ausreichend Abstand zueinander aufweisen, insbesondere diejenigen Fenster 3A, 4A für je eines der Bauteile 3, 4, damit sich Ausgasungskanäle 9 zwischen den mit den Fenstern 3A, 4A erzeugten Lotpastedepots ausbilden. Über diese Ausgasungskanäle 9 kann beim Aufschmelzen der Lotpaste in den Lotpastedepots Prozessgas entweichen, ohne dass es zum Losreißen von Lotspritzern kommt.

Gleichzeitig sind die Fenster 3A, 4A noch ausreichend nah beieinander angeordnet, dass sich schlussendlich die Ausgasungskanäle 8 mit Lot aus den dortigen Lotpastedepots verschließen. Schließlich bedeckt also das Lot vollflächig die der Leiterplatte 1 zugewandte Oberfläche des Bauteils 3 und 4. Somit wird eine vollflächige und direkte elektrische Lötverbindung 6 zwischen dem Bauteil 3, 4 und der Leiterplatte 1 geschaffen. In dem Bereich der Leiterplatte 1, in dem die Lötverbindungen 6 und 7 hergestellt werden sollen, ist die Lötstoppmaske 5 daher ausgespart. Also ist dieser Bereich Lötstoppmaske-frei. Entsprechende Fenster in der Lötstoppmaske 5 sind in Fig. 1 und 2 mit dem Bezugszeichen 5A versehen.

Die ersten Fenster 3A, 4A sind jeweils auf einer viereckigen Grundfläche angeordnet. Diese Grundfläche wird beispielsweise durch die Fenster 5A in der Lötstoppmaske definiert. Die ersten Fenster 3A an den Ecken der Grundfläche bilden Eckfenster. In Fig. 2 ist beispielhaft eines der Eckfenster mit dem Bezugszeichen 3A' versehen. Diese Eckfenster 3A' für das Bauteil 3 sind gegenüber den anderen ersten Fenstern 3A für dieses Bauteil 3 vergrößert ausgeführt. Darüber hinaus sind die ersten Fenster 3A, 4A so angeordnet, dass die Ausgasungskanäle 9 rechtwinklig zueinander verlaufen. Sie sind auch so angeordnet, dass die Ausgasungskanäle 9 eine konstante Breite aufweisen. Alternativ können die Ausgasungskanäle 9 jedoch auch anderweitig verlaufen, beispielsweise sternförmig und/oder eine sich in Längsrichtung des jeweiligen Kanals 9 ändernde Breite aufweise.

Wenn mehr als einer der vorgefertigten Trägerplatten 2 mit der Leiterplatte 1 mittels Lotpaste verlötet werden sollen, ist die Lötschablone 8 seitlich um Bereiche vergrößert, die analog zur Lötschablone 8 aus Fig. 2 ausgeführt sind. Fig. 2 ist also auch so zu verstehen, dass diese lediglich einen Teil einer Lötschablone zeigen kann. Außerdem kann die Lötschablone noch weitere Fenster aufweisen, um Lotpastedepots für Lötverbindungen mit optional vorhandenen weiteren Bauteilen zu ermöglichen.

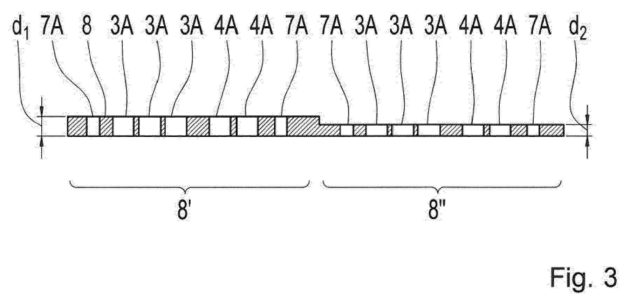

Fig. 3 zeigt eine Variante der Lötschablone 8 gemäß Fig. 2 in einem Längsschnitt durch erste und zweite Fenster 3A, 4A, 7A der Lötschablone 8.

Die Lötschablone dient dazu, Lotpastedepots zum Verlöten von mindestens zwei Trägerplatten mit darauf angeordneten, vorbestückten Bauteilen auf eine gemeinsame Leiterplatte zu schaffen. Beide dieser Trägerplatten können entsprechend Fig. 1 mit den darauf angeordneten Bauteilen (Bauteile 3, 4) ausgeführt sein. Die Bauteile befinden sich dann also entsprechend Fig. 1 nach dem Auflöten zwischen Trägerplatte und Leiterplatte.

Die beiden Trägerplatten mit den vorbestückten Bauteilen sollen später räumlich benachbart auf der gemeinsamen Leiterplatte angeordnet sein. Daher sind die entsprechenden Fenster 3A, 4A, 7A nebeneinander in der Lotschablone 8 vorgesehen. Der Bereich 8' der Lötschablone enthält die Fenster 3A, 4A, 7A für die Lotpastedepots zum Auflöten der Bauteile der ersten Trägerplatte und dieser Trägerplatte selbst. Der Bereich 8" der Lötschablone enthält die Fenster 3A, 4A, 7A für die Lotpastedepots zum Auflöten der Bauteile der zweiten Trägerplatte sowie der Trägerplatte selbst.

Vorliegend ist eine der beiden Trägerplatten und die darauf angeordneten Bauteile bereits mit einer zumindest geringen Menge Lotmasse versehen, d.h. damit vorbestückt. Diese Lotmasse dient zum späteren Verlöten mit der Leiterplatte und befindet sich also bereits vor dem Verlöten mit der Leiterplatte auf dieser Trägerplatte und den zugehörigen Bauteilen. Zum Auflöten dieser Trägerplatte mit den zugehörigen Bauteilen auf die Leiterplatte ist also eine geringere Menge Lotpaste in den Lotpastedepots erforderlich, als für die andere Trägerplatte und die dortigen Bauteile, welche nicht vorab mit Lotmasse versehen sind. Dem wird dadurch Rechnung getragen, dass die Lotschablone 8 im Bereich 8", wo die geringere Menge Lotpaste bzw. Lotmasse erforderlich ist, dünner ausgeführt ist, als im Bereich 8'. Dadurch weisen die mittels der Lötschablone 8 erzeugten Lotpastedepots in den Bereichen 8' und 8" unterschiedliche Volumina auf. Entsprechend unterschiedlich sind die auf die Leiterplatte aufgebrachte Lotmassen in den Bereichen 8' und 8".

Auch die Lötschablone 8 gemäß Fig. 3 kann sich in der dargestellten Weise beliebig weit fortsetzen. Somit können beliebig viele Trägerplatten mit darauf vorbestückten Bauteilen mit der gemeinsamen Leiterplatte mittels Lotmasse in Lotpastedepots verlötet werden. Je nach benötigter Lotmasse zum Auflöten der Trägerplatten auf die gemeinsame Leiterplatte kann dann die Lötschablone 8 über entsprechende Dicken in den zugehörigen Bereichen verfügen. Der Übergang zwischen den Bereichen kann, wie in Fig. 3 ersichtlich, als Stufe oder alternativ als Schräge oder als anderer geeigneter Übergang ausgeführt sein.

Die Herstellung der Leiterplattenanordnung gemäß Fig. 1 und 2 erfolgt mittels der Lötschablone 8 wie folgt:

Vorab wird die Leiterplatte mit der Lötstoppmaske 5 beschichtet. Dabei werden die Fenster 5A von der Lötstoppmaske 5 ausgespart.

In einem ersten Schritt wird dann auf die Leiterplatte 1 Lotpaste in Lotpastedepots mittels der Lötschablone 8 aufgetragen. Dazu wird die Lötschablone 8 auf die Leiterplatte 1 aufgelegt (mit der in Fig. 3 flachen, unteren Seite der Lötschablone 8). Anschließend wird Lotpaste in die ersten und zweiten Fenster 3A, 4A, 7A gefüllt, beispielsweise durch eine Walze oder einen Rakel. Dadurch wird je Fenster 3A, 4A, 7A ein Lotpastedepot gebildet. Die Lötschablone 8 wird dann von der Leiterplatte 1 abgenommen. Zurück auf der Leiterplatte 1 verbleibt die Lotpaste in den Lotpastedepots.

In einem zweiten Schritt wird die vorgefertigte Trägerplatte 2 mit den elektrischen Bauteilen 3, 4 auf die Lotpastedepots auf der Leiterplatte 1 angeordnet. Dies beinhaltet sowohl ein Auflegen oder Anlegen der Trägerplatte 2 auf die Leiterplatte 1, als auch ein Auflegen oder Anlegen der Leiterplatte 1 auf die Trägerplatte 2.

In einem dritten Schritt werden schließlich die Lötverbindungen 6 der Bauteile 3, 4 mit der Leiterplatte 1 sowie die Lötverbindungen 7 zwischen der Trägerplatte 2 und der Leiterplatte 1 durch Aufschmelzen der Lotpaste in den Lotpastedepots hergestellt. Dabei kann Prozessgas durch die Ausgasungskanäle 9 entweichen. Wenn dies erfolgt ist, verschließen sich die Ausgasungskanäle 9 von alleine durch flüssiges Lot der aufgeschmolzenen Lotpaste benachbarter Lotpastedepots. Die Unterschiedlichen Weite der jeweiligen Lötverbindungen 6, 7 wird durch unterschiedliche Höhen der Lotpastedepots, also durch die jeweilige Breite der Lötschablone 8, ausgeglichen.

### Bezugszeichen

- 1: Leiterplatte
- 2: Trägerplatte
- 3: elektrisches Bauteil
- 3A: Fenster
- 3A': Eckfenster
- 4: elektrisches Bauteil
- 4A: Fenster
- 5: Lötstoppmaske
- 5A: Fenster
- 6: Lötverbindung
- 7: Lötverbindung
- 7A: Fenster
- 8: Lötschablone
- 8', 8": Bereich
- 9: Ausgasungskanal

- d₁, d₂: Dicke

## Patentansprüche

**1.** Lötschablone (8) zur Herstellung einer Leiterplattenanordnung, die über eine vorgefertigte Trägerplatte (1) mit einer Bauteilseite mit zumindest zwei darauf vorbestückten elektrischen Bauteilen (3, 4) verfügt und die über eine Leiterplatte (1) verfügt, die mit den Bauteilen (3, 4) auf der Bauteilseite der Trägerplatte (2) mittels Lotpaste verlötet ist,
**gekennzeichnet durch** mehrere erste Fenster (3A, 4A) in der Lötschablone (8) für jedes der elektrischen Bauteile (3, 4) auf der Bauteilseite der Trägerplatte (2), zum Aufbringen von Lotpaste in jeweils ein Lotpastedepot auf die Leiterplatte (1), das zur Herstellung der Lötverbindung (6) zwischen den elektrischen Bauteilen (3, 4) und der Leiterplatte (1) dient,
wobei die ersten Fenster (3A, 4A) ausreichend Abstand zueinander aufweisen, um Ausgasungskanäle (9) zwischen den Lotpastedepots zu bilden.

**2.** Lötschablone (8) nach Anspruch 1, wobei die ersten Fenster (3A, 4A) für das jeweilige elektrische Bauteil (3, 4) ausreichend nah beieinander angeordnet sind, dass sich während eines Aufschmelzens der Lotpaste die Ausgasungskanäle (9) mit Lot daraus verschließen.

**2.** Lötschablone (8) nach Anspruch 1 oder 2, wobei in einem Teil der Lötschablone (8), welche zu einem Randbereich der Trägerplatte (2) korrespondiert, ein oder mehrere zweite Fenster (7A) zum Aufbringen von Lotpaste in je ein Lotpastedepot vorgesehen sind, das jeweils zur Herstellung der direkten Lötverbindung (7) zwischen der Leiterplatte (1) und der Trägerplatte (2) dient.

**3.** Lötschablone (8) nach Anspruch 2, wobei zumindest zwei gegenüberliegende zweite Fenster (7A) vorgesehen sind, die jeweils in einem Teil der Lötschablone (8) angeordnet sind, die zu dem Randbereich der Trägerplatte (2) korrespondieren, und wobei die ersten Fenster (3A, 4A) zwischen diesen zweiten Fenstern (7A) angeordnet sind.

**4.** Lötschablone (8) nach einem der Ansprüche 1 bis 3, wobei die ersten Fenster (3A) für das jeweilige elektrische Bauteil (3, 4) auf einer viereckigen Grundfläche angeordnet sind, wobei erste Fenster (3A') an den Ecken der Grundfläche vorgesehen sind und diese gegenüber den anderen ersten Fenster (3A) für dieses Bauteil (3) vergrößert ausgeführt sind.

**5.** Lötschablone (8) nach einem der Ansprüche 1 bis 4, wobei die ersten Fenster (3A, 4A) so angeordnet sind, dass die Ausgasungskanäle (9) zwischen den Lotpastedepots rechtwinklig zueinander verlaufen.

**6.** Lötschablone (8) nach einem der Ansprüche 1 bis 5, wobei die ersten Fenster (3A, 4A) so angeordnet sind, dass die Ausgasungskanäle (9) zwischen den Lotpastedepots eine konstante Breite aufweisen.

**7.** Lötschablone (8) nach einem der vorhergehenden Ansprüche zur Herstellung einer Leiterplattenanordnung, die über zumindest zwei der vorgefertigten Trägerplatte (1) verfügt und die über eine gemeinsame Leiterplatte (1) verfügt, die mit den Bauteilen (3, 4) auf den Bauteilseiten der zumindest zwei Trägerplatten (2) mittels Lotpaste verlötet ist,
mit den Fenstern (3A, 4A, 7A) zum Aufbringen von Lotpaste in jeweils ein Lotpastedepot auf die gemeinsame Leiterplatte (1)
wobei die Fenster (3A, 4A, 7A) für die eine Trägerplatte (2) in einem Bereich (8') der Lötschablone (8) angeordnet sind und die Fenster (3A, 4A, 7A) für die andere Trägerplatte (2) in einem anderen Bereich (8") der Lötschablone (8) angeordnet sind, wobei eine Dicke (d₁) der Lötschablone (8) in dem einen Bereich (8') unterschiedlich ist zu der Dicke (d₂) der Lötschablone (8) in dem anderen Bereich (8").

**8.** Verfahren zur Herstellung einer Leiterplattenanordnung, die über eine vorgefertigte Trägerplatte (1) mit einer Bauteilseite mit zumindest zwei darauf vorbestückten elektrischen Bauteilen (3, 4) verfügt und die über eine Leiterplatte (1) verfügt, die mit den Bauteilen (3, 4) auf der Bauteilseite der Trägerplatte (2) mittels Lotpaste verlötet ist, **dadurch gekennzeichnet, dass**
in einem ersten Schritt auf die Leiterplatte (1) Lotpaste in Lotpastedepots mittels einer Lötschablone (8) nach einem der Ansprüche 1 bis 8 aufgetragen wird, und
in einem zweiten Schritt die vorgefertigte Trägerplatte (2) mit den elektrischen Bauteilen (3, 4) auf die Lotpastedepots auf der Leiterplatte (1) angeordnet wird, und
in einem dritten Schritt die Lötverbindungen (6) der Bauteile (3, 4) mit der Leiterplatte (1) durch Aufschmelzen der Lotpaste in den Lotpastedepots hergestellt wird.

**9.** Verfahren nach Anspruch 8, wobei die damit hergestellte Leiterplattenanordnung auch eine direkte Lötverbindung (7) zwischen der Leiterplatte (1) und der Trägerplatte (2) aufweist, wozu
in einem Teil der Lötschablone (8), welche zu einem Randbereich der Trägerplatte (2) korrespondiert, zumindest ein zweites Fenster (7A) zum Aufbringen von Lotpaste in ein Lotpastedepot vorgesehen ist, das zur Herstellung der direkten Lötverbindung (7) zwischen der Leiterplatte (1) und der Trägerplatte (2) dient, wobei in dem dritten Schritt diese direkten Lötverbindung (7) durch Aufschmelzen der Lotpaste in dem zugehörigen Lotpastedepot hergestellt wird.
